# EUROPÄISCHE PATENTSCHRIFT

(11) **EP 0 920 635 B1**
(45) Veröffentlichungstag und Bekanntmachung des Hinweises auf die Patenterteilung: **09.10.2002**
(21) Anmeldenummer: 97934418.1
(22) Anmeldetag: 14.07.1997
(51) Int. Cl.: G01R 31/00

(54) **DIAGNOSEVERFAHREN FÜR ELEKTRISCHE GERÄTE**
DIAGNOSTIC PROCEDURE FOR ELECTRICAL APPLIANCES
PROCEDE DIAGNOSTIQUE POUR APPAREILS ELECTRIQUES

(30) Priorität: 22.08.1996 DE 19633785
(43) Veröffentlichungstag der Anmeldung: 09.06.1999
(73) Patentinhaber: ROBERT BOSCH GMBH, 70442 Stuttgart (DE)
(72) Erfinder: WIETZKE, Joachim, D-31141 Hildesheim (DE); GROEGER, Klaus-Erwin, D-31199 Diekholzen (DE)
(86) Internationale Anmeldenummer: DE9701476
(87) Internationale Veröffentlichungsnummer: WO98008103

(56) Entgegenhaltungen:
- EP-A- 0 231 607
- EP-A- 0 671 631
- WO-A-88/02122
- WO-A-89/06839
- WO-A-92/14216

## Beschreibung

### Stand der Technik

Die Erfindung geht aus von einem Diagnoseverfahren für elektrische Geräte, insbesondere Autoradiogeräte, nach der Gattung des Hauptanspruchs.

Das Dokument EP-A-0 671 631 zeigt ein solches Diagnoseverfahren.

Es sind Autoradiogeräte bekannt, die über einen Test-, Abgleich- und Startinterfacevorrichtung verfügen. Dieses sehr schnelle BUS-Interface ermöglicht im Fertigungsdurchlauf, aber auch im Service schnelle und standardisierte Testfolgen, die rechnergesteuert durchgeführt werden. Dazu wird in den Geräten in einem Speicher eine Minimalsoftware integriert, die diese Tests unterstützt. Diese Software, die im allgemeinen im RAM-Speicher hinterlegt wird, kann eine Testsoftware, die von außen an das Interface angeschlossen wird, laden und starten. Dazu ist lediglich eine kurze Programmroutine notwendig. Nach Beendigung der Tests wird das Ergebnis über die Schnittstelle zurückgemeldet. Die Testzeiten sind dabei möglichst kurz zu halten, was durch geeignete Auslegung des Datenbus zwischen Steuerrechner und zu testendem Gerät erreicht wird.

Weiterhin sind Autoradiogeräte bekannt, die eine Leseeinreichtung zur Einführung einer Chipkarte aufweisen. Die Chipkarte enthält einen Sicherheitscode. Nur dann, wenn der Sicherheitscode über die Chipkarte mit der im Autoradio gespeicherten Codierung übereinstimmt, ist eine Inbetriebnahme des Autoradios möglich.

### Vorteile der Erfindung

Das erfindungsgemäße Diagnoseverfahren mit den Merkmalen des Hauptanspruchs hat demgegenüber den Vorteil, daß eine Diagnose der Funktionen des Gerätes möglich ist, ohne das Gerät aus dem Fahrzeug ausbauen zu müssen. Weiterhin ist eine Fehlersuche auch unter Ausnutzung der Geräteumgebung direkt im Einbauzustand möglich. Damit wird eine Diagnose auf die realen Betriebsbedingungen, z. B. durch Einbeziehung aller angeschlossenen Komponenten ausgedehnt. Das Diagnoseverfahren findet direkt am Gerät statt, es ist keine Verkabelung, kein Anlöten von Anschlußdrähten notwendig, es muß auch kein Rechner oder Tester angeschlossen werden.

Durch die in den Unteransprüchen aufgeführten Maßnahmen ist eine vorteilhafte Weiterbildung und Verbesserung des im Hauptanspruch angegebenen Diagnoseverfahrens möglich. Besonders vorteilhaft ist es, daß die Ergebnisse der Diagnose wieder auf die Chipkarte geschrieben werden, die die Testsoftware enthält.

Weiterhin ist es von Vorteil, daß die Ergebnisse auch direkt auf das Display des Gerätes ausgegeben werden können.

Für manche Testfälle ist es erforderlich, größere Testprogramme in das Gerät zu laden, so daß die Speichermöglichkeiten einer einzelnen Chipkarte nicht ausreichen. Es ist aber nach unserem erfindungsgemäßen Verfahren einfach möglich, die Testsoftware auf mehrere Chipkarten zu verteilen und nacheinander in das Gerät einzulesen.

### Zeichnung

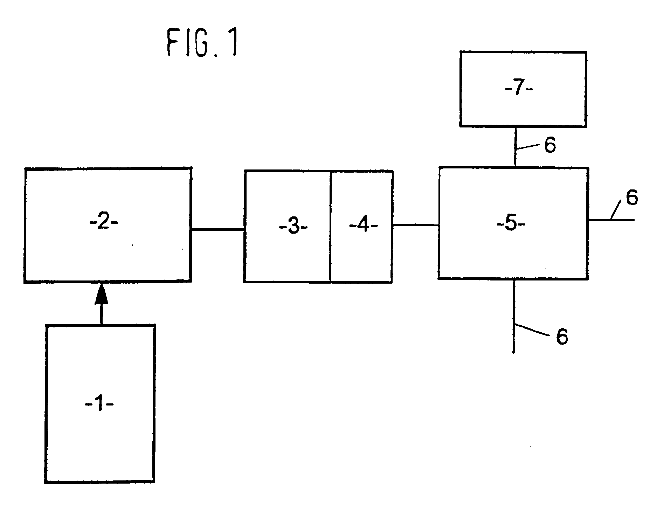

Ein Ausführungsbeispiel der Erfindung ist in der Zeichnung dargestellt und in der nachfolgenden Beschreibung näher erläutert. Es zeigt Figur 1 schematisch den Aufbau eines Gerätes mit Chipkarteninterface.

### Beschreibung des Ausführungsbeispiels

Figur 1 zeigt schematisch den Aufbau eines Gerätes, das mit dem erfindungsgemäßen Diagnoseverfahren untersucht wird. Eine Chipkarte 1 wird dabei in die im Gerät vorgesehene Leseeinheit 2 eingeführt und über die ISO-Schnittstelle kontaktiert. Über die IS0-Schnittstelle werden die auf der Chipkarte enthaltenen Daten, im allgemeinen die Testsoftware, in den Speicher 3 geladen. Der Ladevorgang selbst, wird von einer Laderoutine, die in einem nichtflüchtigen Speicher 4 enthalten ist, gesteuert. Die gesamte Steuerung des Systems liegt bei einem Mikroprozessor 5. Das Gerät führt jetzt mit Hilfe der im Speicher 3 befindlichen Testroutine eine Diagnose seines gesamten Systems durch, während das komplette Systemm über die Anschlüsse 6 mit dem Prozessor verbunden ist..

Die Testsoftware mit den unterschiedlichen Testfunktionen wird auf der Chipkarte, im allgemeinen einer Speicher- bzw. Multifunktionskarte abgelegt. In Abhängigkeit vom Testumfang bzw. der Größe des verfügbaren Speichers auf der Chipkarte kann sich der Gesamttest auch auf mehreren Karten mit entsprechender Testsoftware verteilen. Wird eine derartige mit Testsoftware geladene Karte im Kartenschacht kontaktiert, wird das zu testende Gerät in den Testmodus versetzt. Dadurch wird die Testsoftware vom Ladeprogramm 4 über das ISO-Interface in den Speicherbereich, das RAM, des Geräteprozessors geladen und gestartet. Der Start des Testprogramms wird entweder gleich durch die Software ausgelöst oder der Benutzer gibt über eine Taste oder über eine Codekarte den Beginn des Tests vor. Die vom System gemeldeten Fehler und Ergebnisse können nun entweder auf dem Display 7 angezeigt und/oder auf die Chipkarte zurückgeschrieben werden. Die testende Person entnimmt die Chipkarte dem Gerät und kann unabhängig vom Gerät die Diagnose stellen. Vorteilhaft ist es dabei, daß eine solche Diagnose am Gerät selbst möglich ist, so daß man das Gerät selbst nicht in eine Werkstatt oder ein Labor bringen muß.

## Patentansprüche

1. Diagnoseverfahren für elektrische Geräte, insbesondere Autoradiogeräte, die einen Mikroprozessor (5), einen Speicher (3, 4) und eine Vorrichtung (2) zur Aufnahme und zum Lesen von Chipkarten (1) besitzen, wobei eine Testsoftware die Diagnose des Geräts durchführt, und wobei eine Chipkarte (1) in die Vorrichtung (2) eingeführt wird, **dadurch gekennzeichnet, daß**
a) der Mikroprozessor (5) eine Laderoutine im Speicher (3, 4) aufruft,
b) die Testsoftware aus einem Speicher der Chipkarte (1) in den Speicher (3, 4) des Geräts geladen und gestartet wird,
c) und daß die Testsoftware Ergebnisse ermittelt, die ausgegeben werden.

2. Diagnoseverfahren nach Anspruch 1, **dadurch gekennzeichnet, daß** die Ergebnisse der Testssoftware auf die Chipkarte (1) geschrieben werden.

3. Diagnoseverfahren für Geräte nach Anspruch 1, **dadurch gekennzeichnet, daß** die Ergebnisse der Testsoftware auf einem Display (7) des Geräts ausgegeben werden.

4. Diagnoseverfahren nach Anspruch 1 bis 3, **dadurch gekennzeichnet, daß** die Testsoftware über eine Folge von Chipkarten in das Gerät eingelesen wird.

## Claims

1. Method of diagnosis for electrical appliances, particularly car radios, which have a microprocessor (5), a memory (3, 4) and an apparatus (2) for holding and for reading chip cards (1), where a piece of test software carries out the diagnosis on the appliance, and where a chip card (1) is inserted into the apparatus (2), **characterized in that**
a) the microprocessor (5) calls a loading routine in the memory (3, 4),
b) the test software is loaded from a memory on the chip card (1) into the memory (3, 4) of the appliance and is started,
c) and **in that** the test software ascertains results which are output.

2. Method of diagnosis according to Claim 1, **characterized in that** the results of the test software are written to the chip card (1).

3. Method of diagnosis for appliances according to Claim 1, **characterized in that** the results of the test software are output on a display (7) on the appliance.

4. Method of diagnosis according to Claim 1 to 3, **characterized in that** the test software is read into the appliance using a succession of chip cards.

## Revendications

1. Procédé de diagnostic d'appareils électriques, notamment d'autoradios, comprenant un microprocesseur (5), une mémoire (3, 4) et un dispositif (2) pour recevoir et lire des cartes à puce (1), un programme d'essais effectuant le diagnostic de l'appareil en introduisant une carte à puce (1) dans le dispositif (2),
**caractérisé en ce que**
a) le microprocesseur (5) appelle une routine de chargement dans la mémoire (3, 4),
b) le programme d'essais est chargé à partir d'une mémoire de la carte à puce (1) dans la mémoire (3, 4) de l'appareil et ce programme est lancé, et
c) le programme d'essais détermine des résultats qui sont émis.

2. Procédé de diagnostic selon la revendication 1,
**caractérisé en ce que**
les résultats du programme d'essais sont inscrits sur la carte à puce (1).

3. Procédé de diagnostic selon la revendication 1,
**caractérisé en ce que**
les résultats du programme d'essais sont émis sur un afficheur (7) de l'appareil.

4. Procédé de diagnostic selon l'une quelconque des revendications 1 à 3,
**caractérisé en ce que**
les programmes d'essais sont enregistrés par une série de cartes à puce dans l'appareil.
